# EUROPEAN PATENT APPLICATION

(11) **EP 4 818 849 A1**
(43) Date of publication of application: **07.10.2026**
(21) Application number: 26168881.6
(22) Date of filing: 30.03.2026
(51) Int. Cl.: G06F 1/16, H04M 1/02, G09F 9/30

(54) **DISPLAY DEVICE AND ELECTRONIC DEVICE INCLUDING THE SAME**

(30) Priority: 01.04.2025 KR 20250041932; 30.05.2025 KR 20250071216
(71) Applicant: Samsung Display Co., Ltd., Yongin-si, Gyeonggi-do (KR)
(72) Inventor: Kim, Youngdo, Yongin-si, Gyeonggi-Do (KR); Kim, Wonjin, Yongin-si, Gyeonggi-Do (KR); Lee, Donghyeon, Yongin-si, Gyeonggi-Do (KR)
(74) Representative: Gulde & Partner

(57) **Abstract**

Provided is a foldable display device (DD). A protective member (PP) provided at an uppermost side of a display panel (DP) of the display device (DD) extends to overlap a housing (HM) on a plane. Accordingly, a bezel region of the display device (DD) may be reduced. Entrance of foreign substances into an inside of the display device (DD) may be blocked, prevented, or reduced. A resin (PR) is on a side surface of the display device (DD). The impact resistance of the display device (DD) may be improved.

## Description

### BACKGROUND

Embodiments of the present disclosure herein relate to a display device and an electronic device including the same, and for example, to a foldable display device and an electronic device including the same.

A display device includes a display region that is activated according to an electrical signal. The display device may sense an input applied from the outside through the display region and concurrently (e.g., simultaneously) display various suitable images to provide information to a user. With the recent development of display devices having various suitable shapes, display regions having diverse shapes are being implemented.

### SUMMARY

Embodiments of the present disclosure provide a foldable display device having a reduced bezel region and improved impact resistance.

Embodiments of the present disclosure also provide an electronic device including the display device.

An embodiment of the present disclosure provides a display device including a display panel configured to be foldable, a protective member provided above the display panel, a lower member provided below the display panel, and a resin attached to at least a first side surface of the display panel and a first side surface of the lower member corresponding to the first side surface of the display panel and provided inside the protective member on a plane.

In an embodiment, the display panel may include a first portion facing the protective member, may include a second portion provided below the lower member, and may include a third portion (may also be referred to independently as bent portion in other embodiments) between the first portion and the second portion and which may be bent.

In an embodiment of the present disclosure, the display device may further include a dummy resin attached to a second side surface of the lower member facing the third portion and which may be positioned between the second side surface of the lower member and the third portion.

In an embodiment, the resin and the dummy resin may include substantially the same material as each other.

In an embodiment, the first portion may include a first non-folding region, a second non-folding region, and a folding region between the first non-folding region and the second non-folding region. The folding region may extend in a first direction, and the first non-folding region and the second non-folding region may be spaced apart from each other along a second direction crossing the first direction.

In an embodiment, the resin may be further provided outside the third portion, and the first side surface of the display panel and the third portion may be spaced apart from each other in the second direction.

In an embodiment, each of the display panel and the lower member may further include a third side surface and a fourth side surface facing each other in the first direction. The resin may be attached to the third side surface and the fourth side surface of each of the display panel and the lower member.

In an embodiment, the resin may not be attached to a region corresponding to the folding region of each of the third side surface and the fourth side surface.

In an embodiment, the resin may include a silicone-based resin, a urethane-based resin, a urethane acrylate-based resin, or a combination thereof.

In an embodiment, at about -25 °C to about 80 °C, the resin may have an elongation of about 50% or more and may have a storage modulus of about 10 MPa or less.

In an embodiment, the resin may have a closed-line shape on a plane.

In an embodiment of the present disclosure, an electronic device includes a display device, a hinge assembly coupled to the display device and configured to convert the display device between an unfolded state and a folded state, and a housing coupled to the display device and the hinge assembly. The display device includes a display panel, a protective member provided above the display panel and attached to the housing, a lower member provided below the display panel, and a resin attached to at least a first side surface of the display panel and a first side surface of the lower member corresponding to the first side surface of the display panel and provided inside the protective member on a plane.

In an embodiment, the hinge assembly may generate slip between the protective member, the display panel, and the lower member in the folded state, and the lower member may slip more than the display panel with respect to the protective member.

In an embodiment, the display panel may include a first portion facing the protective member, may include a second portion provided below the lower member, and may include a third portion (may also be referred to independently as bent portion in other embodiments) between the first portion and the second portion and which may be folded. The first portion may include a first non-folding region, a second non-folding region, and a folding region between the first non-folding region and the second non-folding region.

In an embodiment, the folding region may extend in a first direction, and the first non-folding region and the second non-folding region may be spaced apart from each other along a second direction crossing the first direction.

In an embodiment, the hinge assembly may include a central frame corresponding to the folding region, may include a first frame corresponding to the first non-folding region and which may be hinge-coupled to the central frame via a first shaft provided inside the central frame, and may include a second frame corresponding to the first non-folding region and hinge-coupled to the central frame via a second shaft provided inside the central frame and provided farther from the display device than the first shaft. The display device may be coupled to the second frame.

In an embodiment of the present disclosure, the display device may further include a dummy resin attached to a second side surface of the lower member facing the third portion and between the second side surface of the lower member and the third portion.

In an embodiment, the resin may be provided outside the third portion, and the first side surface of the display panel and the third portion may be spaced apart from each other in the second direction.

In an embodiment, the resin may include a silicone-based resin, a urethane-based resin, a urethane acrylate-based resin, or a combination thereof.

In an embodiment, at about -25 °C to about 80 °C, the resin may have an elongation of about 50% or more and a storage modulus of about 10 MPa or less.

In an embodiment of the present disclosure, an electronic device includes a display device, a hinge assembly coupled to the display device and configured to convert the display device between an unfolded state and a folded state, and a housing coupled to the display device and the hinge assembly. The display device includes a protective member attached to the housing, a display panel provided below the protective member and including a bent portion, and a resin attached to an outer surface of the bent portion of the display panel and provided inside the protective member on a plane.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE FIGURES

The accompanying drawings are included to provide a further understanding of the subject matter of the present disclosure, and are incorporated in and constitute a part of this specification. The drawings illustrate embodiments of the present disclosure and, together with the description, serve to explain principles of the present disclosure. In the drawings:
FIG. 1 is a block diagram of an electronic device according to an embodiment of the present disclosure;
FIG. 2 illustrates schematic diagrams of electronic devices according to embodiments of the present disclosure;
FIG. 3A is an exploded perspective view of an electronic device according to an embodiment of the present disclosure;
FIG. 3B is a plan view of a display panel according to an embodiment of the present disclosure;
FIGS. 3C and 3D are cross-sectional views of a display device according to an embodiment of the present disclosure;
FIG. 4A is a side view illustrating an unfolded state of the electronic device according to an embodiment of the present disclosure;
FIG. 4B is a side view illustrating a folded state of the electronic device according to an embodiment of the present disclosure;
FIGS. 5A and 5B are cross-sectional views of the electronic device according to an embodiment of the present disclosure;
FIGS. 5C to 5E illustrate the deformation of a resin according to a change in the state of the electronic device;
FIG. 6A is a rear view of the electronic device according to an embodiment of the present disclosure;
FIGS. 6B to 6D are cross-sectional views of the electronic device according to an embodiment of the present disclosure;
FIGS. 7 to 9 are cross-sectional views of the electronic device according to an embodiment of the present disclosure; and
FIG. 10 is a rear view of the electronic device according to an embodiment of the present disclosure.

### DETAILED DESCRIPTION

In this specification, it will be understood that if (e.g., when) an element (or region, layer, portion, and/or the like) is referred to as being "on", "connected to" or "coupled to" another element, it can be directly on, connected or coupled to the other element, or intervening elements may be present.

Like reference numerals refer to like elements throughout. In the drawings, the thicknesses, ratios, and dimensions of elements may be exaggerated for effective description of the technical contents. As used herein, the term "and/or" includes any and all combinations that the associated configurations can define.

Although the terms first, second, and/or the like may be used herein to describe various components, these components should not be limited by these terms. These terms are used only to distinguish one component, part, region, layer, or portion from another component, part, region, layer, or portion. For example, without departing from the scope of the present disclosure, a first component, a first part, a first region, a first layer, or a first portion may be referred to as a second component, a second part, a second region, a second layer, or a second portion, and similarly, a second component, a second part, a second region, a second layer, or a second portion may also be referred to as a first component, a first part, a first region, a first layer, or a first portion. Singular expressions include plural expressions unless the context clearly indicates otherwise.

In embodiments, terms, such as "below", "lower", "above", "upper" and the like, are used herein for ease of description to describe one element's relation to another element(s) as illustrated in the figures. The above terms are relative concepts and are described based on the directions indicated in the drawings.

It will be understood that the terms "include" and/or "have", if (e.g., when) used in this specification, specify the presence of stated features, integers, steps, operations, elements, components and/or groups thereof, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the present disclosure will be described with reference to the accompanying drawings.

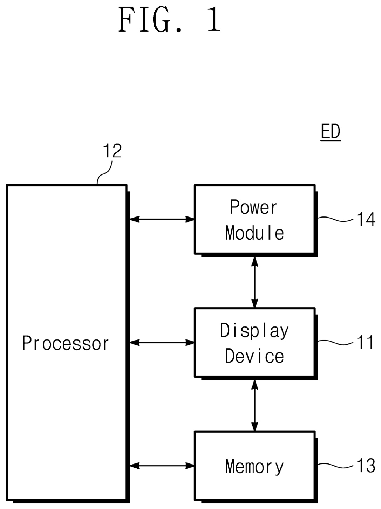

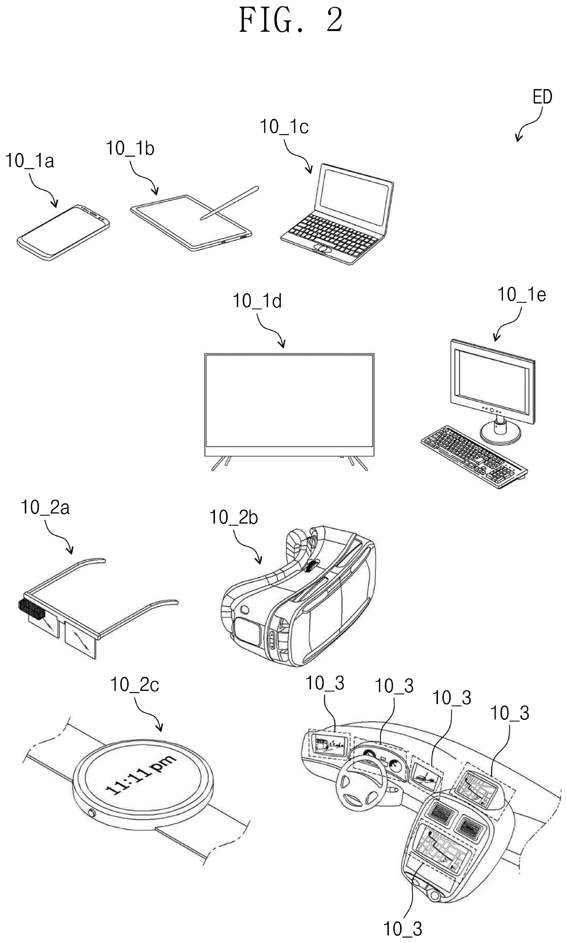

FIG. 1 is a block diagram of an electronic device ED according to an embodiment of the present disclosure. FIG. 2 illustrates schematic diagrams of electronic devices ED according to embodiments of the present disclosure.

Referring to FIG. 1, the electronic device ED according to an embodiment of the present disclosure may include a display device 11, a processor 12, a memory 13, and a power module 14.

The processor 12 may include at least one selected from a central processing unit (CPU), an application processor (AP), a graphic processing unit (GPU), a communication processor (CP), an image signal processor (ISP), and a controller.

The memory 13 may store data information necessary or useful for the operation of the processor 12 or the display device 11. If (e.g., when) the processor 12 executes an application stored in the memory 13, an image data signal and/or an input control signal is transmitted to the display device 11, and the display device 11 may process the received signal and output image information through a display screen.

The power module 14 may include a power supply module, such as a power adapter and/or a battery device, and a power conversion module that converts power supplied by the power supply module to generate power necessary or useful for the operation of the electronic device ED.

The processor 12, the power module 14, and the memory 13 that are described above may be included in the display device 11 and/or may be separated from the display device 11 as a separate module. The processor 12, the power module 14, and the memory 13 may be provided inside a housing, which constitutes the exterior of the electronic device ED, in a form distinct from the display device 11.

Referring to FIG. 2, the electronic devices ED according to embodiments of the present disclosure may include not only general information-providing electronic devices such as a smart phone 10_1a, a tablet PC 10_1b, a laptop 10_1c, a TV 10_1d, and a desktop monitor 10_1e, but also wearable electronic devices such as smart glasses 10_2a, a head-mounted display device 10_2b, and a smart watch 10_2c, as well as vehicle electronic devices 10_3 such as a center information display (CID) provided in an instrument cluster, center fascia, and/or dashboard of a vehicle, and/or a room mirror display.

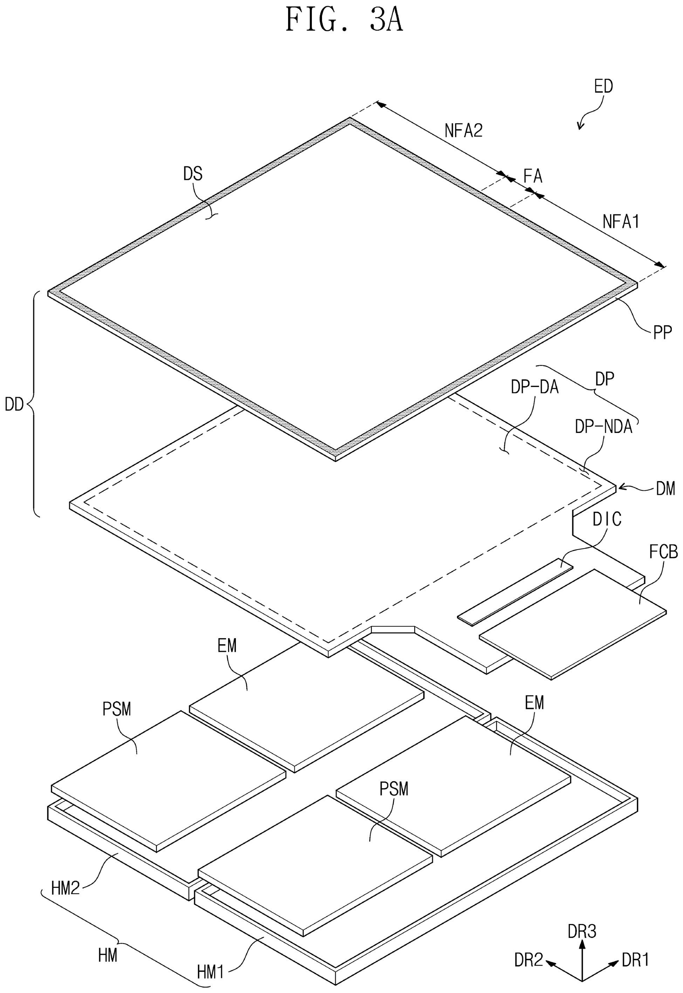

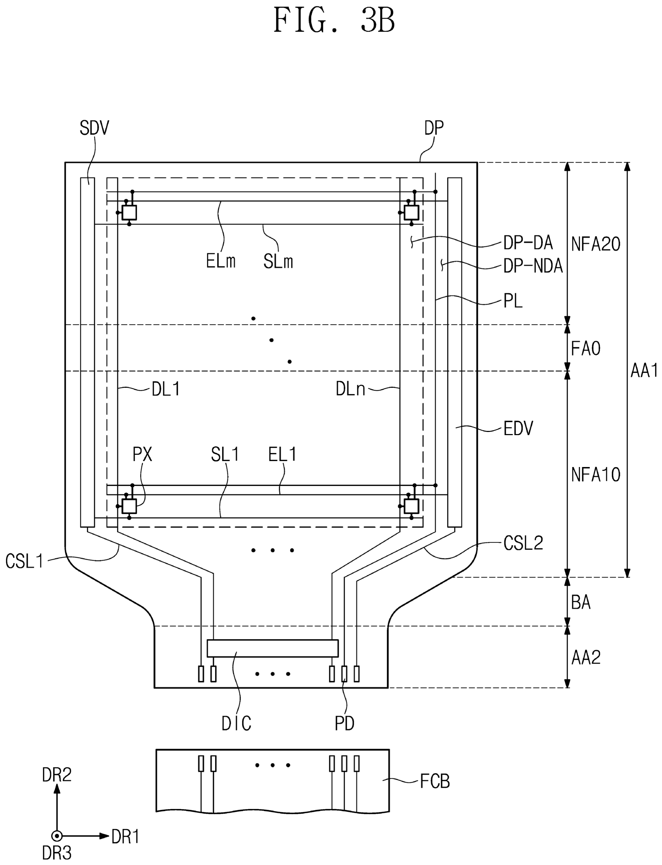

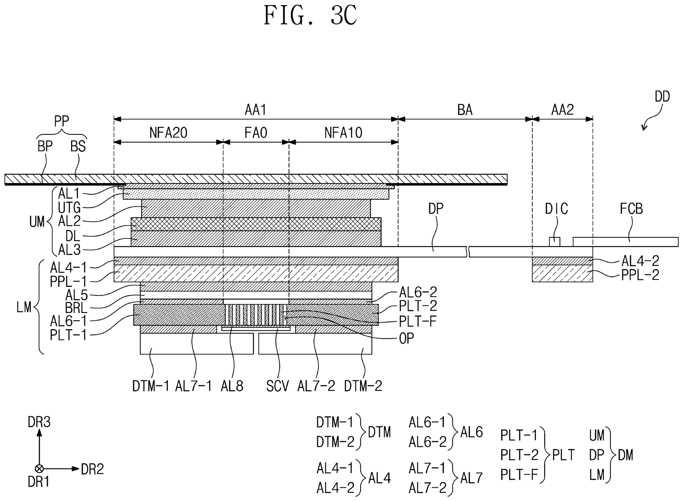

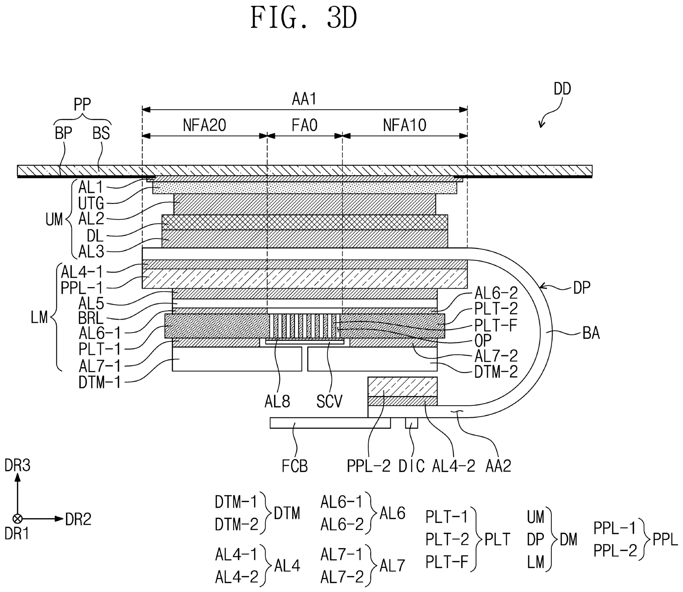

FIG. 3A is an exploded perspective view of an electronic device ED according to an embodiment of the present disclosure. FIG. 3B is a plan view of a display panel DP according to an embodiment of the present disclosure. FIG. 3C and FIG. 3D are cross-sectional views of a display device DD according to an embodiment of the present disclosure.

Hereinafter, the display device 11 described with reference to FIGS. 1 and 2 may be described as the display device DD. In embodiments, although a foldable mobile phone is described as an example of the electronic device ED, the subject matter of the present disclosure may be applied to various suitable electronic devices including the mobile phone.

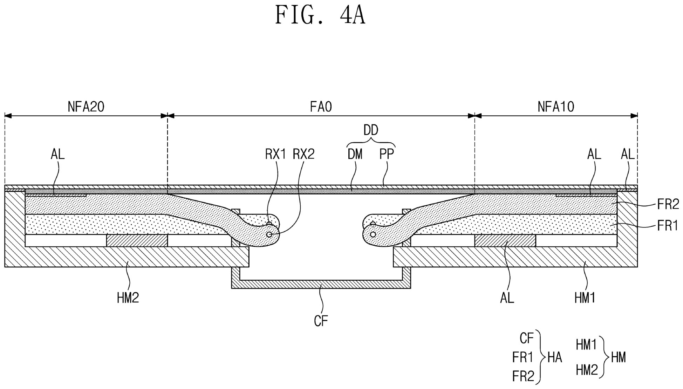

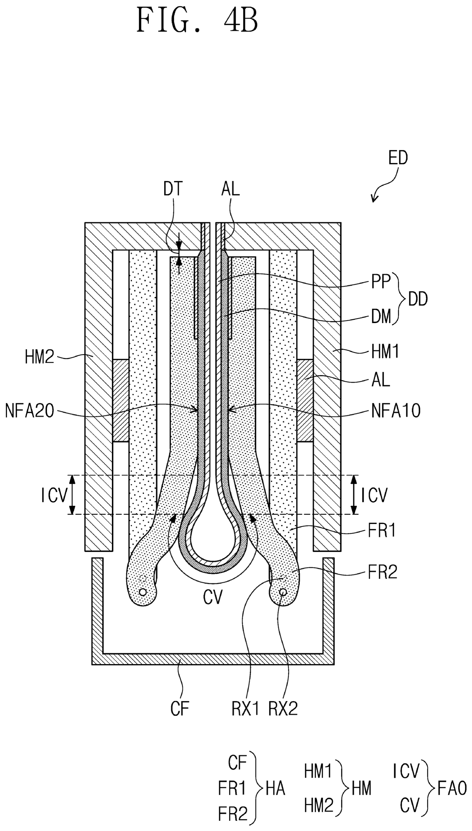

As illustrated in FIG. 3A, the electronic device ED may include a display device DD, an electronic module EM, a power module PSM, and a housing HM. In embodiments, the electronic device ED may further include a hinge assembly HA (see FIGS. 4A and 4B) configured to control the folding operation of the electronic device ED.

The display device DD may generate an image and sense an external input. The display device DD may include a protective member PP (and/or a protective plate and/or protective film) and a display module DM. The protective member PP provides a front surface of the display device DD and the electronic device ED.

The electronic device ED may include a display surface DS provided by the protective member PP. The display surface DS is defined by a first direction DR1 and a second direction DR2 crossing the first direction DR1. An image IM generated in the display device DD may be provided to a user through the display surface DS. Hereinafter, the direction of the normal line with respect to a plane defined by the first direction DR1 and the second direction DR2 is defined as a third direction DR3.

In FIG. 3A, three regions distinguished by the operation of the electronic device ED are illustrated based on the protective member PP. The electronic device ED may be deformed between a folded state and an unfolded state. Accordingly, the electronic device ED may include a first non-folding region NFA1, a second non-folding region NFA2, and a folding region FA disposed therebetween. The folding region FA may be a relatively narrow region and extend in the first direction DR1. In a folded state of the electronic device ED, the folding region FA forms or has a set or predetermined curvature. According to this embodiment, the first non-folding region NFA1 and the second non-folding region NFA2 face each other in a folded state of the electronic device ED. This state may be defined as a state in which the electronic device ED is in-folded.

The display module DM may include at least a display panel DP. The display panel DP is not particularly limited and may include, for example, a light-emitting display panel such as an organic light-emitting display panel and/or an inorganic light-emitting display panel.

In FIG. 3A, only the display panel DP is illustrated in the stacked structure of the display module DM, but substantially, the display module DM may further include an upper member UM (see FIG. 3C) on the display panel DP and below the protective member PP and a lower member LM (see FIG. 3C) below the display panel DP. A further description of the stacked structure of the display module DM is further described herein.

The display panel DP includes a display region DP-DA and a non-display region DP-NDA. The display module DM may further include a driving chip DIC and a flexible circuit board FCB. The driving chip DIC may be on the non-display region DP-NDA of the display panel DP. The flexible circuit board FCB may be coupled to the non-display region DP-NDA of the display panel DP. The flexible circuit board FCB may be connected to a main circuit board.

The driving chip DIC may include driving elements, such as a data driving circuit, to drive the pixels of the display panel DP. In FIG. 3A, the driving chip DIC mounted on the display panel DP is illustrated, but the embodiment of the present disclosure is not limited thereto. For example, the driving chip DIC may be mounted on the flexible circuit board FCB.

The electronic module EM may include the processor 12 and the memory 13 of FIG. 1. The electronic module EM may include a main circuit board, and the processor 12 and the memory 13 may be mounted on the main circuit board and/or electrically connected to the main circuit board through a flexible circuit board. The electronic module EM is electrically connected to the power module PSM.

The housing HM is coupled to the display device DD, for example, to the protective member PP, to protect other modules. The housing HM is illustrated as an example as including a first housing HM1 and a second housing HM2 that respectively correspond to the first non-folding region NFA1 and the second non-folding region NFA2.

Referring to FIG. 3A, the electronic module EM may be provided in each of the first housing HM1 and the second housing HM2, and the power module PSM may be provided in each of the first housing HM1 and the second housing HM2. In embodiments, the electronic module EM provided in the first housing HM1 and the electronic module EM provided in the second housing HM2 may be electrically connected to each other through a flexible circuit board, and the two electronic modules EM may include different components.

In embodiments, the electronic device ED may further include an electro-optical module. The electro-optical module may be an electronic component that outputs and/or receives an optical signal. The electro-optical module may include a camera module and/or a proximity sensor. The camera module may capture an external image through a partial region of the display panel DP.

The display panel DP will be described in more detail with reference to FIG. 3B. Pixels PX may be provided in the display region DP-DA. A scan driving circuit SDV, a data driving circuit, and a light-emitting driving circuit EDV may be provided in the non-display region DP-NDA. The data driving circuit may be included in the driving chip DIC.

The display panel DP includes a first portion AA1, a second portion AA2, and a third portion BA (may also be referred to independently as bent portion BA in other embodiments) that are distinguished from each other in the second direction DR2. The second portion AA2 and the third portion BA may be portions of the non-display region DP-NDA. The third portion BA is between the first portion AA1 and the second portion AA2.

The first portion AA1 faces the protective member PP of FIG. 3A. The first portion AA1 may include a first non-folding region NFA10, a second non-folding region NFA20, and a folding region FA0 corresponding to the first non-folding region NFA1, the second non-folding region NFA2, and the folding region FA of the electronic device ED. The first non-folding region NFA10, the second non-folding region NFA20, and the folding region FA0 of the first portion AA1 may be equally applied not only to the display panel DP but also to other components of the display device DD itself and the display module DM illustrated in FIG. 3A.

In the first direction DR1, the length of the third portion BA may be smaller than the length of the first portion AA1. The length of the third portion BA in the first direction DR1 may be reduced toward the second portion AA2. Accordingly, the third portion BA may be bent more easily.

The display panel DP may include a plurality of pixels PX, a plurality of scan lines SL1 to SLm, a plurality of data lines DL1 to DLn, a plurality of light-emitting lines EL1 to ELm, first and second control lines CSL1 and CSL2, a voltage line PL (for example, a power voltage line), and a plurality of pads PD. In embodiments, m and n are natural numbers. The pixels PX may be connected to the scan lines SL1 to SLm, the data lines DL1 to DLn, and the light-emitting lines EL1 to ELm.

The scan lines SL1 to SLm may extend in the first direction DR1 to be connected to the scan driving circuit SDV. The data lines DL1 to DLn may extend in the second direction DR2 to be connected to the driving chip DIC via the third portion BA. The light-emitting lines EL1 to ELm may extend in the first direction DR1 to be connected to the light-emitting driving circuit EDV.

The voltage line PL may include a portion extending in the second direction DR2 and a portion extending in the first direction DR1. The portion extending in the first direction DR1 and the portion extending in the second direction DR2 may be provided in different layers. The portion of the voltage line PL extending in the second direction DR2 may extend to the second portion AA2 via the third portion BA. The voltage line PL may provide a first voltage to the pixels PX.

The first control line CSL1 may be connected to the scan driving circuit SDV and extend toward the lower end of the second portion AA2 via the third portion BA. The second control line CSL2 may be connected to the light-emitting driving circuit EDV and extend toward the lower end of the second portion AA2 via the third portion BA.

On a plane, the pads PD may be adjacent to the lower end of the second portion AA2. The driving chip DIC, the voltage line PL, the first control line CSL1, and the second control line CSL2 may be connected to the pads PD. The flexible circuit board FCB may be electrically connected to the pads PD through an anisotropic conductive adhesive layer (e.g., an anisotropic electrically conductive adhesive layer).

Referring to FIGS. 3C and 3D, the upper member UM and the lower member LM of the display module DM are additionally illustrated compared to FIG. 3A. The upper member UM and the lower member LM described below are only one embodiment, and the configurations of the upper member UM and the lower member LM are not limited thereto.

In FIGS. 3C and 3D, the display device DD in an unfolded state is illustrated as an example. FIG. 3C illustrates a state before the third portion BA of the display panel DP is bent, and FIG. 3D illustrates a state after the third portion BA of the display panel DP is bent. As illustrated in FIG. 3D, if (e.g., when) the first portion AA1 is disposed below the protective member PP in a state in which the third portion BA is bent at a set or predetermined curvature, the second portion AA2 is disposed below the first portion AA1 and the lower member LM.

In embodiments, an input sensor may be on the display panel DP illustrated in FIGS. 3C and 3D. The input sensor may be formed directly on the display panel DP through a continuous process. For example, the input sensor may be on the uppermost surface of the display panel DP.

Referring to FIGS. 3C and 3D, the protective member PP may be defined as a structure attached to the housing HM (see FIGS. 4A and 4B) described herein below. The protective member PP may include at least one base layer BS and have a single-layer or multi-layer structure. The base layer BS may include a plastic film (e.g., a polymer film) and/or a glass substrate. The thickness of the base layer BS may be about 100 µm or less, for example, about 50 µm to about 80 µm.

The base layer BS may include polyimide, polycarbonate, polyamide, triacetylcellulose, polymethylmethacrylate, polyethylene terephthalate, or a combination thereof.

The protective member PP may further include a functional coating layer on the upper surface of the base layer BS. The functional coating layer may include at least one selected from a hard coating layer, an anti-fingerprint layer, and an antireflection layer.

In this embodiment, the protective member PP may further include a bezel pattern BP on the lower surface of the base layer BS. The bezel pattern BP may be formed as a colored light-blocking film, for example, by a coating method. The bezel pattern BP may include a base material and a dye and/or pigment mixed into the base material.

The bezel pattern BP defines a bezel region of the electronic device ED. The bezel pattern BP overlaps the non-display region DP-NDA (see FIG. 3A) of the display device DD on a plane. In an embodiment of the present disclosure, the bezel pattern BP may be omitted or provided in another layer of the upper member UM.

The upper member UM may include a thin film glass substrate UTG, an upper film DL, and at least one selected from adhesive layers AL1, AL2, and AL3. In this embodiment, the upper member UM may include a first adhesive layer AL1 configured to bond the protective member PP and the thin film glass substrate UTG together, a second adhesive layer AL2 configured to bond the thin film glass substrate UTG and the upper film DL together, and a third adhesive layer AL3 configured to bond the upper film DL and the display panel DP together.

The thickness of the thin film glass substrate UTG may be about 15 µm to about 45 µm. The thin film glass substrate UTG may be chemically strengthened glass. The thin film glass substrate UTG may minimize or reduce the formation of wrinkles even if (e.g., when) folding and unfolding are repeated.

At least one selected from the adhesive layers AL1, AL2, and AL3 may be a pressure sensitive adhesive (PSA) film and/or an optically clear adhesive (OCA) member. The adhesive layers described herein below may also include the same adhesive as described above.

The upper film DL may include a plastic film (e.g., a polymer film). The upper film DL may include polyimide, polycarbonate, polyamide, triacetylcellulose, polymethylmethacrylate, polyethylene terephthalate, or a combination thereof.

The upper film DL may absorb external impact applied to the front surface of the display device DD. The display panel DP may include color filters that replace a polarizing film, and by omitting the polarizing film, it is possible to reduce anti-impact strength on the front surface of the display device DD. The upper film DL may compensate for the reduced anti-impact strength. In an embodiment of the present disclosure, the upper film DL may be omitted.

The lower member LM may include a panel protection layer PPL, a barrier layer BRL, a support plate PLT, a cover layer SCV, a digitizer DTM, and at least one selected from adhesive layers AL4 to AL8. The lower member LM may include fourth to eighth adhesive layers AL4 to AL8. In an embodiment of the present disclosure, some of the above-described components may be omitted. For example, the barrier layer BRL, the cover layer SCV, the digitizer DTM, and the adhesive layers associated therewith may be omitted.

The panel protection layer PPL may be provided below the display panel DP. The panel protection layer PPL may protect the lower portion of the display panel DP. The panel protection layer PPL may include a flexible synthetic resin film. For example, the panel protection layer PPL may include polyethylene terephthalate.

In an embodiment of the present disclosure, the panel protection layer PPL may not be provided below the third portion BA of the display panel DP. The panel protection layer PPL may include a first panel protection layer PPL-1 configured to protect the first portion AA1 of the display panel DP (see FIG. 3A) and a second panel protection layer PPL-2 configured to protect the second portion AA2.

The fourth adhesive layer AL4 bonds the panel protection layer PPL and the display panel DP together. The fourth adhesive layer AL4 may include a first portion AL4-1 corresponding to the first panel protection layer PPL-1 and a second portion AL4-2 corresponding to the second panel protection layer PPL-2.

If (e.g., when) the third portion BA is bent, the second panel protection layer PPL-2 may be provided below the digitizer DTM together with the second portion AA2. Because the panel protection layer PPL is not provided in the third portion BA, the third portion BA may be bent more easily.

The fifth adhesive layer AL5 bonds the panel protection layer PPL and the barrier layer BRL together. The barrier layer BRL may be provided below the first panel protection layer PPL-1. The barrier layer BRL may increase resistance against compressive force caused by external pressure. Accordingly, the barrier layer BRL may suppress or reduce deformation of the display panel DP. The barrier layer BRL may include a flexible plastic material (e.g., a flexible polymer material) such as polyimide, polyethylene terephthalate, or a combination thereof. In embodiments, the barrier layer BRL may be a colored film having low light transmittance. The barrier layer BRL may absorb light incident from the outside. For example, the barrier layer BRL may be a black synthetic resin film. If (e.g., when) the display device DD is viewed from above a protective member PP, components provided below the barrier layer BRL may not be visible to a user.

The sixth adhesive layer AL6 bonds the barrier layer BRL and the support plate PLT together. The sixth adhesive layer AL6 may include a first portion AL6-1 and a second portion AL6-2 that are spaced apart from each other. The separated distance between the first portion AL6-1 and the second portion AL6-2 corresponds to the width of the folding region FA0 and is greater than the separated distance between digitizers to be further described herein below.

The support plate PLT is provided below the barrier layer BRL. The support plate PLT is configured to support components provided above and to maintain the display device DD in both its unfolded and folded states. The support plate PLT has a strength greater than that of the barrier layer BRL.

The support plate PLT may include a high-strength metal material. The support plate PLT may include a material having an elastic modulus of about 60 GPa or more. The support plate PLT may include a metal material such as, for example, stainless steel.

The support plate PLT may also include a reinforced fiber composite. The support plate PLT may include reinforcing fibers provided inside a matrix portion. The reinforcing fibers may be carbon fibers and/or glass fibers. The matrix portion may include a polymer resin. The matrix portion may include a thermoplastic resin. For example, the matrix portion may include a polyamide-based resin, a polypropylene-based resin, or a combination thereof. For example, the reinforced fiber composite may be carbon fiber reinforced plastic (CFRP), glass fiber reinforced plastic (GFRP), or a combination thereof.

The support plate PLT includes at least a first support portion PLT-1 corresponding to the second non-folding region NFA20 and a second support portion PLT-2 corresponding to the first non-folding region NFA10. The support plate PLT may include a folding portion PLT-F corresponding to the folding region FA0, between the first support portion PLT-1 and the second support portion PLT-2, and having a plurality of openings OP defined therein. If (e.g., when) the display device DD transitions from an unfolded state to a folded state, the folding portion PLT-F may be more easily deformed.

The plurality of openings OP may form a grid pattern in the folding portion PLT-F. Accordingly, the first support portion PLT-1, the second support portion PLT-2, and the folding portion PLT-F may have an integral shape.

The cover layer SCV and the digitizer DTM are provided below the support plate PLT. The cover layer SCV is provided so as to overlap the folding region FA0. The digitizer DTM may include a first digitizer DTM-1 and a second digitizer DTM-2 that overlap the first support portion PLT-1 and the second support portion PLT-2, respectively. A portion of each of the first digitizer DTM-1 and the second digitizer DTM-2 may be provided below the cover layer SCV.

The seventh adhesive layer AL7 bonds the support plate PLT and the digitizer DTM together, and the eighth adhesive layer AL8 bonds the cover layer SCV and the support plate PLT together. The seventh adhesive layer AL7 may include a first portion AL7-1 configured to bond the first support portion PLT-1 and the first digitizer DTM-1 together and a second portion AL7-2 configured to bond the second support portion PLT-2 and the second digitizer DTM-2 together.

The cover layer SCV may be between the first portion AL7-1 and the second portion AL7-2 in the second direction DR2. The cover layer SCV may be spaced apart from the digitizer DTM to prevent or reduce interference with the digitizer DTM if (e.g., when) the display device DD is unfolded. The sum of the thicknesses of the cover layer SCV and the eighth adhesive layer AL8 may be smaller than the thickness of the seventh adhesive layer AL7.

The cover layer SCV may cover the openings OP of the folding portion PLT-F. If (e.g., when) the display device DD is folded, the cover layer SCV is stretched and prevents or reduces entrance of foreign substances into the expanded openings OP. The cover layer SCV may have a lower elastic modulus than the support plate PLT. For example, the cover layer SCV may include, but is not limited to, thermoplastic polyurethane, rubber, and/or silicone.

The digitizer DTM, also referred to as an EMR sensing panel, includes a plurality of loop coils that generate a magnetic field at a set or predetermined resonant frequency corresponding to an electronic pen. The magnetic field formed by the loop coils is applied to an LC resonance circuit composed of an inductor (coil) and a capacitor of the electronic pen. The coil generates a current (e.g., an electric current) in response to the received magnetic field and transmits the generated current to the capacitor. Accordingly, the capacitor charges the current input from the coil and discharges the charged current back to the coil. As a result, the magnetic field at the resonant frequency is emitted from the coil. The magnetic field emitted by the electronic pen may be reabsorbed by the loop coils of the digitizer, thereby making it possible to determine where the electronic pen is provided in proximity to a touch screen.

The first digitizer DTM-1 and the second digitizer DTM-2 may be different digitizers that may be operated independently of each other, or may be different parts of one digitizer. The digitizer DTM may further include a flexible circuit board electrically connecting the first digitizer DTM-1 and the second digitizer DTM-2 to each other.

FIG. 4A is a side view illustrating an unfolded state of the electronic device ED according to an embodiment of the present disclosure. FIG. 4B is a side view illustrating a folded state of the electronic device ED according to an embodiment of the present disclosure.

FIGS. 4A and 4B may illustrate only some of the components of the electronic device ED illustrated in FIG. 3A, and a hinge assembly HA is additionally illustrated. The hinge assembly HA is coupled to both the display device DD and the housing HM. The display device DD is also coupled to the housing HM. Such coupling may be achieved, for example, through an adhesive layer AL. A portion of the hinge assembly HA may be coupled to the housing HM, and the lowermost member of the display device DD may be coupled to the hinge assembly HA. The protective member PP of the display device DD may be coupled to the housing HM.

As illustrated in FIG. 4A, if (e.g., when) the electronic device ED is in an unfolded state, the folding region FA0 may substantially define one plane together with the first non-folding region NFA10 and the second non-folding region NFA20. In embodiments, the expression 'substantially defining one plane' is not limited to defining an exact mathematical plane. This means that the folding region FA0 in an unfolded state has a very small curvature compared to the folding region FA0 in a folded state which will be further described herein. In embodiments, the deformation of the folding region FA0 caused by extensive folding and unfolding operations within the 'substantially one plane' context is disregarded.

In FIGS. 4A and 4B, for a detailed description of the hinge assembly HA, the folding region FA0 is illustrated as being larger than the first non-folding region NFA10 and the second non-folding region NFA20, but the folding region FA0 substantially has a smaller area than the first non-folding region NFA10 and the second non-folding region NFA20.

As illustrated in FIG. 4B, if (e.g., when) the electronic device ED is in a folded state, the folding region FA0 of the display device DD may be deformed to include a curvature region CV and an inverse curvature region ICV. The inverse curvature region ICV is defined between the curvature region CV and the first non-folding region NFA10 and between the curvature region CV and the second non-folding region NFA20, respectively. A non-curvature region may be further provided between the curvature region CV and the inverse curvature region ICV. In a folded state, the curvature region CV has a diameter larger than the distance between the first non-folding region NFA10 and the second non-folding region NFA20.

The deformation of the display device DD illustrated in FIGS. 4A and 4B may be caused by the operation of the hinge assembly HA. The hinge assembly HA includes a central frame CF, a first frame FR1, and a second frame FR2. Each of the first frame FR1 and the second frame FR2 may form a pair and be on both sides of the central frame CF. The central frame CF is provided to correspond to the folding region FA0, and each of the first frame FR1 and the second frame FR2 form a pair and are provided in the first non-folding region NFA10 and the second non-folding region NFA20, correspondingly.

The hinge assembly HA is described here with a focus on one of the pair of the first frame FR1 and one of the pair of the second frame FR2. The first frame FR1 is hinge-coupled to the central frame CF through a first shaft RX1 positioned inside the central frame CF. The second frame FR2 is hinge-coupled to the central frame CF through a second shaft RX2 provided inside the central frame CF. The second shaft RX2 is provided farther from the display device DD than the first shaft RX1. The first frame FR1 is coupled to the housing HM, and the second frame FR2 is coupled to the display device DD.

In the unfolded state of FIG. 4A, the distances from the first shaft RX1 and the second shaft RX2 to the side surface (or the end) of the housing HM in the second direction DR2 are the same, but in the folded state of FIG. 4B, the distances from the first shaft RX1 and the second shaft RX2 to the side surface of the housing HM are different from each other.

The second shaft RX2 is provided farther from the side surface of the housing HM than the first shaft RX1. In the folded state of FIG. 4B, a gap DT may occur between the side surface of the housing HM and the second frame FR2 by a distance corresponding to the distance between the first shaft RX1 and the second shaft RX2. The gap DT may be several hundred micrometers or less. The gap DT may be about 400 µm to about 700 µm.

In a comparative embodiment in which the display module DM is physically separated from the protective member PP because the protective member PP is coupled to the housing HM, the side surface of the housing HM and the end of the display module DM may be spaced apart from each other by the aforementioned gap DT in a folded state. However, in the display device according to the present embodiment, in which the display module DM is coupled to the protective member PP by an adhesive layer, a slip phenomenon occurs in the display module DM if (e.g., when) transitioning from an unfolded state to a folded state. The slip phenomenon is eliminated if (e.g., when) transitioning from a folded state to an unfolded state. The slip phenomenon that occurs in embodiments of the present disclosure is defined as reverse-direction slip, and a further description thereof is provided herein.

If (e.g., when) the electronic device ED is repeatedly deformed between the unfolded state of FIG. 4A and the folded state of FIG. 4B (hereinafter, deformation of the electronic device ED), the display module DM is not fractured and a slip phenomenon occurs in the display module DM because, as explained with reference to FIGS. 3C and 3D, the adhesive layers AL1 to AL8 are between the components of the display module DM. If (e.g., when) the electronic device ED is deformed, shear stress is applied to the stacked components of the display module DM and the adhesive layers therebetween. The magnitudes of the shear stress applied to the stacked components and the adhesive layers therebetween are different depending on the stacking positions. Greater deformation (or elongation) occurs in an adhesive layer to which greater shear stress is applied. Because the amounts of deformation (or elongation) of the adhesive layers are different depending on the stacking positions, a slip phenomenon occurs in the display module DM.

The configuration of the hinge assembly HA described in FIGS. 4A and 4B is not particularly limited. It is sufficient that a hinge assembly HA capable of deforming the above-described display device DD and causing reverse-direction slip in the display module DM is applied to the electronic device ED according to embodiments of the present disclosure. For example, the second frame FR2 may be transformed into a sliding plate. The sliding plate may be moved such that its distance from the side surface of the housing HM is suitably variable between unfolded and folded states. In the unfolded state, the sliding plate may be moved so as to be relatively adjacent to the side surface of the housing HM and relatively distant from the central frame CF, and in the folded state, the sliding plate may be moved so as to be relatively distant from the side surface of the housing HM and relatively adjacent to the central frame CF.

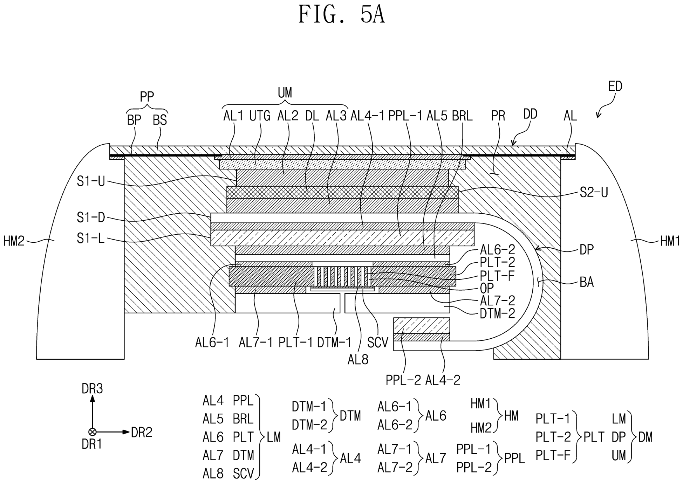

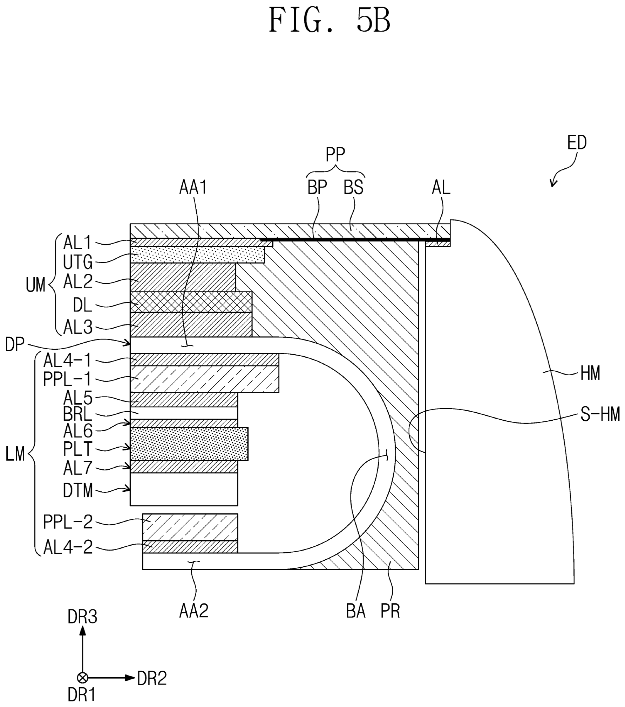

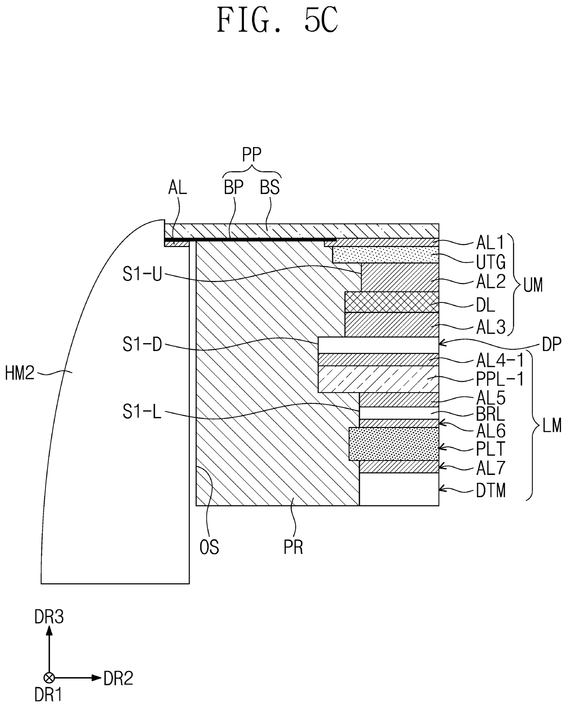

FIGS. 5A and 5B are cross-sectional views of the electronic device ED according to an embodiment of the present disclosure. FIGS. 5C to 5E illustrate the deformation of a resin PR according to a change in the state of the electronic device ED.

Referring to FIG. 5A, the display device DD coupled to the housing HM is illustrated. The protective member PP may be coupled to the housing HM through an adhesive layer AL. Accordingly, a path through which external foreign substances enter the inside of the electronic device ED may be blocked or reduced. Although the bezel pattern BP is illustrated as being provided in a region overlapping the housing HM, the embodiment of the present disclosure is not limited thereto. The bezel pattern BP may be removed or moved to a different location, and the base layer BS may be coupled to the housing HM through an adhesive layer AL.

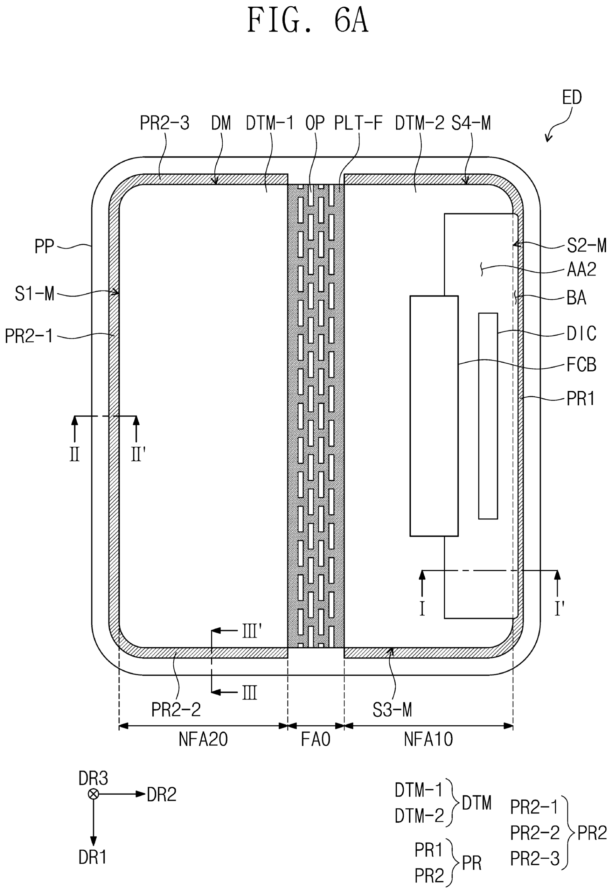

The display device DD according to this embodiment may include a resin PR. The resin PR may be attached to any one side surface of the display module DM and provided inside the protective member PP on a plane. The resin PR according to this embodiment may be attached to at least a first side surface S1-D of the display panel DP and a first side surface S1-L of the lower member LM corresponding to the first side surface S1-D of the display panel DP and may be provided inside the protective member PP on a plane. The resin PR may also be attached to a first side surface S1-U of the upper member UM corresponding to the first side surface S1-D of the display panel DP. The first side surface S1-D of the display panel DP, the first side surface S1-L of the lower member LM, and the first side surface S1-U of the upper member UM define a first side surface S1-M (see FIG. 6A) of the display module DM.

The resin PR may be further attached to the outside of the third portion BA that is spaced apart from or face the first side surface S1-D of the display panel DP in the second direction DR2. The resin PR may be further attached to a second side surface S2-U of the upper member UM facing the first side surface S1-U of the upper member UM in the second direction DR2. The outer side surface of the bent third portion BA of the display panel DP and the second side surface S2-U of the upper member UM define a second side surface S2-M (see FIG. 6A) of the display module DM. In an embodiment of the present disclosure, the resin PR may be provided at least on the second side surface S2-M of the display module DM.

The resin PR may be spaced apart from an inner side surface S-HM of the housing HM. FIG. 5B illustrates as an example an arrangement relationship between a portion of the resin PR corresponding to the second side surface S2-M of the display module DM and the inner side surface S-HM of the housing HM. The distance between the resin PR and the inner side surface S-HM of the housing HM may be smaller than that in an electronic device having a forward-direction slip structure. Although the present disclosure is not limited by any particular mechanism or theory, it is believed that this is because, in the electronic device ED having a reverse-direction slip structure, the resin PR is not pushed toward the inner side surface S-HM of the housing HM if (e.g., when) slip occurs in the display device DD.

The resin PR may be formed by applying a resin material along the side surface of the display module DM and then curing it while the third portion BA is bent, as in the display device DD illustrated in FIG. 3D. The resin PR may be cured by an ultraviolet (UV) curing method. In embodiments, the resin PR may be cured by concurrently (e.g., simultaneously) providing a UV light source and a humid atmosphere, by using a UV light source and a heat source at the same time (or substantially the same time), and/or by thermal curing at a temperature of less than about 80 °C. The resin PR may further include carbon black, carbon nanotubes, iron oxide, black pigment, and/or black dye. In embodiments, in order to increase the curing rate of the resin PR, a UV light source and a humid atmosphere may be provided concurrently (e.g., simultaneously), and/or a UV light source and a heat source may be used at the same time (or substantially the same time).

In an embodiment of the present disclosure, the resin PR may be in contact with the inner side surface S-HM of the housing HM. Depending on the manufacturing order of the resin PR, the resin PR may be attached to both the side surface of the display module DM and the inner side surface S-HM of the housing HM. For example, after the display device DD is coupled to the housing HM, a resin material is applied, and if (e.g., when) cured, the resin PR may be attached to the inner side surface S-HM of the housing HM.

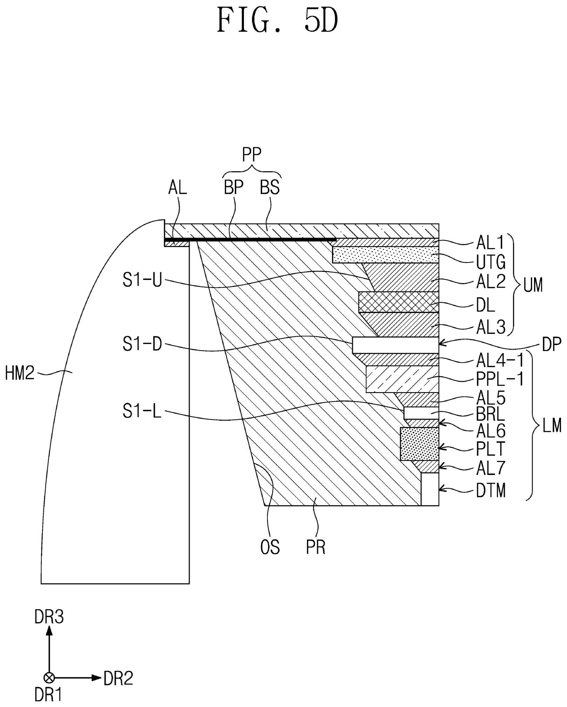

FIG. 5C illustrates the resin PR in an unfolded state, and FIG. 5D illustrates the resin PR in a folded state. In the unfolded state, the resin PR compensates for the step difference between the first side surface S1-D of the display panel DP, the first side surface S1-L of the lower member LM, and the first side surface S1-U of the upper member UM and provides a flat outer side surface OS. The outer side surface OS may be parallel to the third direction DR3. In the folded state, shear stress is applied to the adhesive layers AL1 to AL8, which are stretched, resulting in a slip phenomenon in the display device DD.

The slip phenomenon of the display device DD that occurs in the folded state is caused by the operation of the hinge assembly HA described in FIGS. 4A and 4B. Going from the upper member UM to the lower member LM, the amount of slip accumulates, resulting in greater slip between the protective member PP and the lower member LM than between the protective member PP and the display panel DP. With respect to the protective member PP, the lower member LM moves more than the display panel DP.

The resin PR may be deformed according to the slip phenomenon of the display module DM. Because the resin PR is not attached to the second housing HM2, the resin PR may be easily deformed to provide an inclined outer side surface OS. If (e.g., when) the electronic device ED is repeatedly deformed between the unfolded state of FIG. 4A and the folded state of FIG. 4B (hereinafter, deformation of the electronic device ED), the resin PR is repeatedly deformed between the state of FIG. 5C and the state of FIG. 5D.

In order to suppress or reduce damage to the resin PR due to externally applied shear stress, the resin PR has a high elongation and a low elastic modulus in a range of about -20 °C to about 85 °C, preferably of about -30 °C to about 90 °C. If (e.g., when) the resin PR has an elongation of about 50% or more, preferably of about 60% or more, in the range of about -20 °C to about 85 °C, preferably of about -30 °C to about 90 °C, the resin PR may have a storage modulus of about 10 MPa or less, preferably of about 9 MPa or less. The resin PR may include a silicone-based resin, a urethane-based resin, a urethane acrylate-based resin, or a combination thereof.

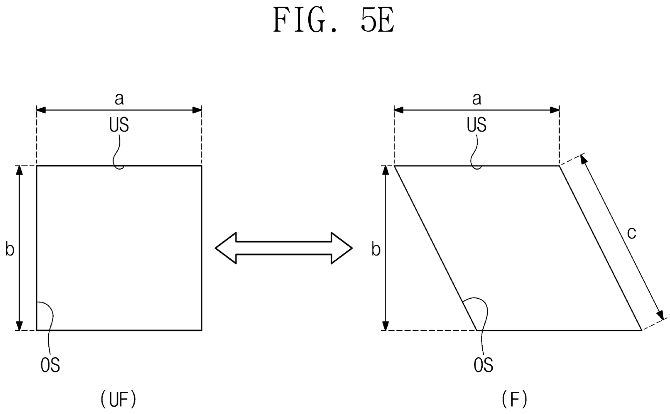

The deformation characteristics of the resin PR are described with reference to FIG. 5E. If (e.g., when) transitioning from an unfolded state UF to a folded state F, the length of the outer side surface OS of the resin PR increases from a first length b to a second length c. Although there may be a difference depending on the stacked structure of the display module DM, in this embodiment, the resin PR is described as an example in which a length a of an upper surface US of the resin PR and the first length b of the outer side surface OS of the resin PR are substantially the same as each other in the unfolded state UF. The length a of the upper surface US of the resin PR: the first length b of the outer side surface OS of the resin PR: the second length c of the outer side surface OS of the resin PR has a ratio of 1:1:√2. If (e.g., when) the outer side surface OS of the resin PR is deformed from the first length b to the second length c, a tensile strain of about 41% may occur. In order to prevent or reduce damage to the resin PR during the above-described deformation, it is preferable that the resin PR have a percent elongation of about 50% or more, preferably of about 60% or more, in a temperature range of about -20 °C to about 85 °C, preferably of about - 30 °C to about 90 °C.

According to a comparative example, if (e.g., when) transitioning from the unfolded state of FIG. 5C to the folded state of FIG. 5D, forward-direction slip may occur. If (e.g., when) the forward-direction slip occurs, the amount of slip accumulates more in components provided higher relative to the digitizer DTM. For example, the thin film glass substrate UTG may slip the farthest from the digitizer DTM. The accumulated amount of slip may be measured by measuring the distance between the end of the thin film glass substrate UTG and the end of the digitizer DTM in the second direction DR2 after folding.

If (e.g., when) there is a resin PR between the side surface of the display module DM and the housing HM, the deformed display module DM pushes the resin PR toward the housing HM. The pushed resin PR may penetrate the housing HM and leak out, or may push up the protective member PP. To prevent or reduce such defects, the resin PR must be suitably or sufficiently spaced apart from the housing HM. As a result, if (e.g., when) forward-direction slip occurs, it is difficult to reduce the area of the bezel region.

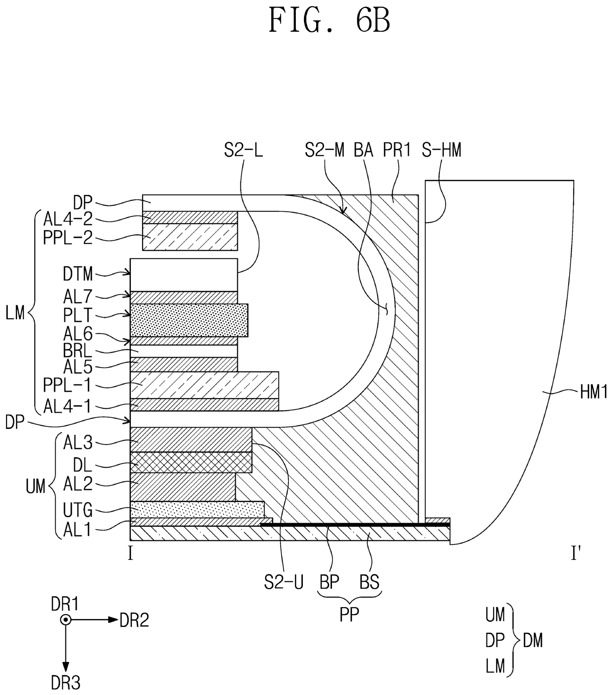

FIG. 6A is a rear view of the electronic device ED according to an embodiment of the present disclosure. FIGS. 6B to 6D are cross-sectional views of the electronic device ED according to an embodiment of the present disclosure.

In FIG. 6A, the housing HM and the hinge assembly HA are not illustrated, and in FIGS. 6B to 6D, a portion of the housing HM is illustrated.

Referring to FIG. 6A, the digitizer DTM, the second portion AA2 of the display panel DP on the digitizer DTM, and the flexible circuit board FCB are illustrated. Based on FIG. 3C, the digitizer DTM is provided at the lowermost part of the display device DD. In embodiments, the folding portion PLT-F of the support plate PLT is exposed in a region between the first digitizer DTM-1 and the second digitizer DTM-2.

On a plane, the resin PR is provided inside the protective member PP. In this embodiment, the resin PR may include a first resin PR1 and a second resin PR2. The first resin PR1 and the second resin PR2 may be spaced apart from each other by the folding region FA0 in the second direction DR2. Because the resin PR is not provided in the folding region FA0, the side surface of the display module DM corresponding to the folding region FA0 is exposed from the resin PR. A region of a third side surface S3-M of the display module DM, which corresponds to the folding region FA0, and a region of a fourth side surface S4-M of the display module DM, which corresponds to the folding region FA0, may be exposed from the resin PR.

As illustrated in FIGS. 6A and 6B, the first resin PR1 is attached to the outer side of the third portion BA of the display panel DP. In embodiments, the first resin PR1 is attached to the second side surface S2-U of the upper member UM.

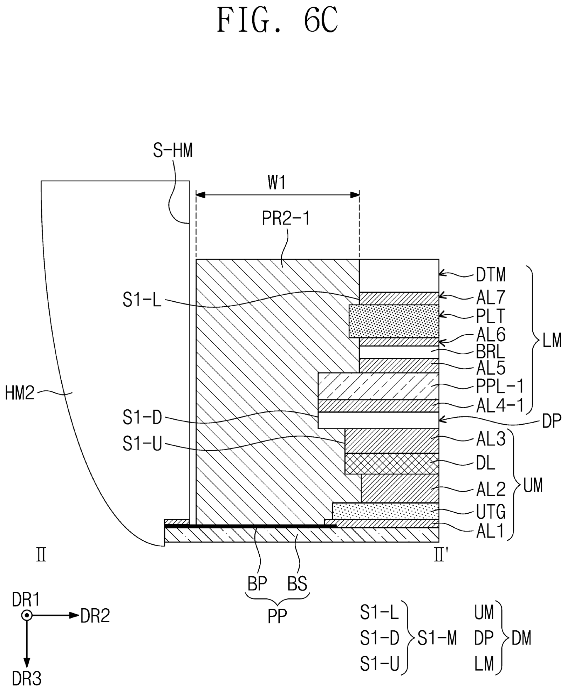

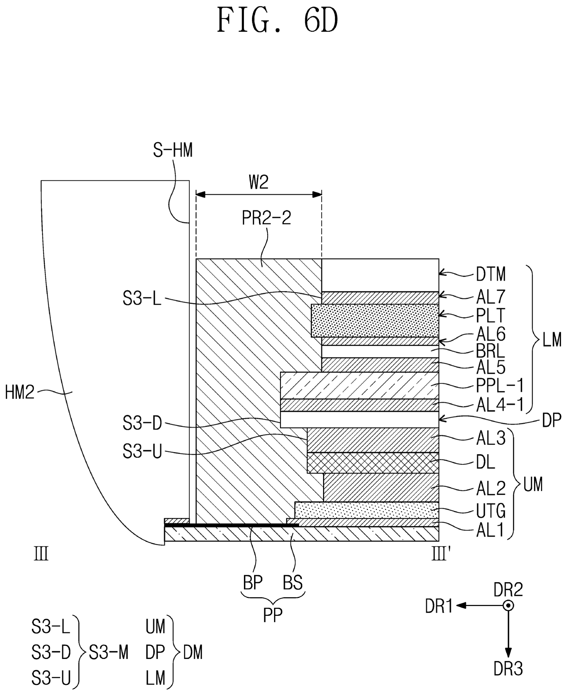

As illustrated in FIGS. 6C and 6D, the second resin PR2 is attached to different side surfaces of the display module DM. Referring to FIG. 6C, a first portion PR2-1 of the second resin PR2 may be attached to the first side surface S1-D of the display panel DP, the first side surface S1-L of the lower member LM, and the first side surface S1-U of the upper member UM. Referring to FIG. 6D, a second portion PR2-2 of the second resin PR2 may be attached to a third side surface S3-D of the display panel DP, a third side surface S3-L of the lower member LM, and a third side surface S3-U of the upper member UM. The third side surface S3-D of the display panel DP, the third side surface S3-L of the lower member LM, and the third side surface S3-U of the upper member UM define the third side surface S3-M of the display module DM of FIG. 6A.

Referring to FIG. 6A, a third portion PR2-3 of the second resin PR2 facing the second portion PR2-2 of the second resin PR2 in the first direction DR1 may also be attached to the fourth side surface S4-M of the display module DM. In embodiments, the fourth side surface S4-M of the display module DM may include a fourth side surface of the display panel DP, a fourth side surface of the lower member, and a fourth side surface of the upper member. The fourth side surface of the display panel DP, the fourth side surface of the lower member, and the fourth side surface of the upper member may face and be symmetrical with the third side surface S3-D of the display panel DP, the third side surface S3-L of the lower member LM, and the third side surface S3-U of the upper member UM illustrated in FIG. 6D in the first direction DR1.

Referring to FIGS. 6C and 6D, a width W1 of the first portion PR2-1 of the second resin PR2 facing the third portion BA of the display panel DP in the second direction DR2 may be larger than a width W2 of the second portion PR2-2 of the second resin PR2. Therefore, the first side surface S1-M of the display module DM may have improved impact resistance compared to the third side surface S3-M of the display module DM.

Hereinafter, the results of a pen pressing test and a fingernail pressing test of the electronic device ED described with reference to FIGS. 5A to 6D will be explained. The results of the pen pressing test and the fingernail pressing test of the electronic device ED demonstrate the effect of improved impact resistance due to the resin PR.

In the pen pressing test, a set or predetermined impact force is applied to the electronic device ED by dropping a pen onto the electronic device ED, and defects that occur in the electronic device ED at that time are evaluated. A pen having a tip diameter of about 0.3 mm and a weight of about 5.8 g was used for the test. The pen pressing test results are shown in Table 1 below.

**Table 1**

| | | 1.4 kgf | 1.5 kgf | 1.6 kgf | 1.7 kgf |
|---|---|---|---|---|---|
| Planar region | | Good | Defective (dark spot) | Defective (crack in the thin film glass substrate) | Defective |
| Bending edge region | Resin - Absent | Defective | Defective | Defective | Defective |
| | Resin - Present | Good | Good | Defective (perforation of the protective member) | Defective |
| Three edge regions | Resin - Absent | Good | Good | Good | Defective (perforation of the protective member) |
| | Resin - Present | Good | Good | Defective (perforation of the protective member) | Defective |

The planar region of Table 1 is the display region DP-DA of FIG. 3B, which overlaps the first non-folding region NFA10, the second non-folding region NFA20, and the folding region FA0 of FIG. 6A. Here, the display region DP-DA is not limited to the display panel DP and is a region of the display device DD corresponding to the display region DP-DA of the display panel DP.

The bending edge region is a region adjacent to the second side surface S2-M of the display module DM described above and corresponds to a portion of the non-display region DP-NDA of FIG. 3B. The remaining three edge regions are regions adjacent to the first, third, and fourth side surfaces S1-M, S3-M, and S4-M of the display module DM described above and correspond to other portions of the non-display region DP-NDA of FIG. 3B. According to Table 1, as the resin PR is provided, the impact resistance of a region corresponding to the third portion BA of the display panel DP of the display device DD is improved. A region adjacent to the third portion BA of the display panel DP may be easily damaged by external impact due to the arrangement of a plurality of signal lines, as described with reference to FIG. 3B, but impact applied to the third portion BA of the display panel DP may be absorbed by placing the resin PR.

The fingernail pressing test is conducted by pressing the electronic device ED using an object with properties similar to those of a user's fingernail, and defects that occur in the electronic device ED at this time are evaluated. The object has a shape similar to that of a fingernail, includes acetal, and has a cross-sectional thickness of about 0.55 mm.

If (e.g., when) the resin PR was omitted, defects occurred in all four edge regions described in Table 1 under both 1 kgf and 2 kgf pressing conditions by the object with properties similar to those of a user's fingernail. If (e.g., when) the resin PR was included, no defects occurred in any of the four edge regions described above under pressing conditions of up to 3 kgf by the same type of object. Even under pressing conditions of up to 8 kgf by the same type of object, no defects occurred in some of the edge regions.

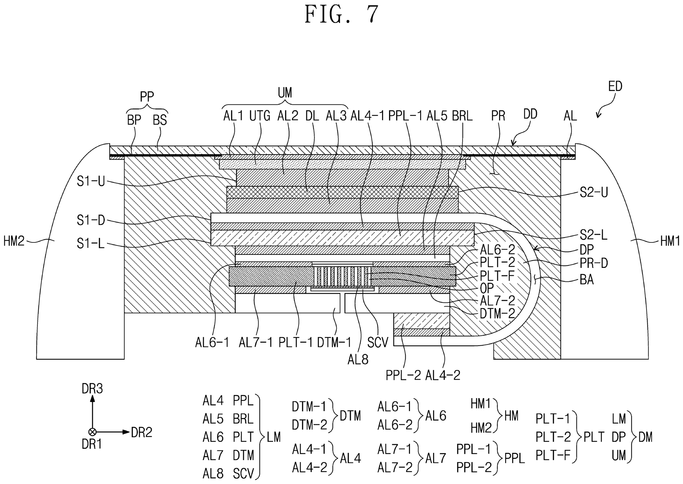

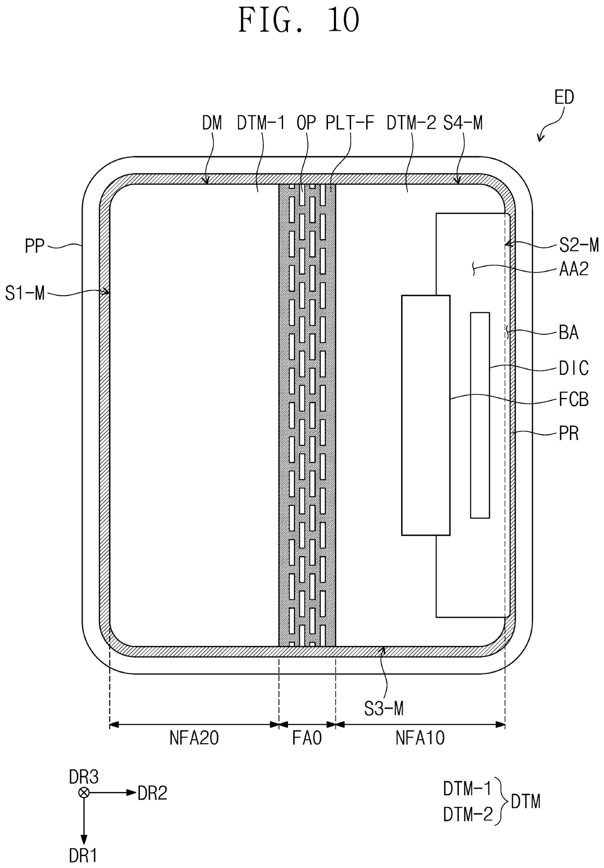

FIGS. 7 to 9 are cross-sectional views of the electronic device ED according to an embodiment of the present disclosure. FIG. 10 is a rear view of the electronic device ED according to an embodiment of the present disclosure. Hereinafter, a detailed description of the same components as those of the electronic device ED described with reference to FIGS. 5A to 6D will be omitted.

Referring to FIG. 7, the display device DD according to this embodiment may further include a dummy resin PR-D. The dummy resin PR-D may include the same material as the resin PR.

The dummy resin PR-D is between a second side surface S2-L of the lower member LM and the third portion BA. The dummy resin PR-D may be attached to the second side surface S2-L of the lower member LM and may not be attached to the third portion BA. For example, the dummy resin PR-D may be in contact with the third portion BA. The dummy resin PR-D may protect the second side surface S2-L of the lower member LM from external impact and support the third portion BA.

A resin material is applied to the second side surface S2-L of the lower member LM and then cured to form the dummy resin PR-D. Hereafter, the third portion BA may be bent, and the second portion AA2 may be attached to the lower side of the digitizer DTM.

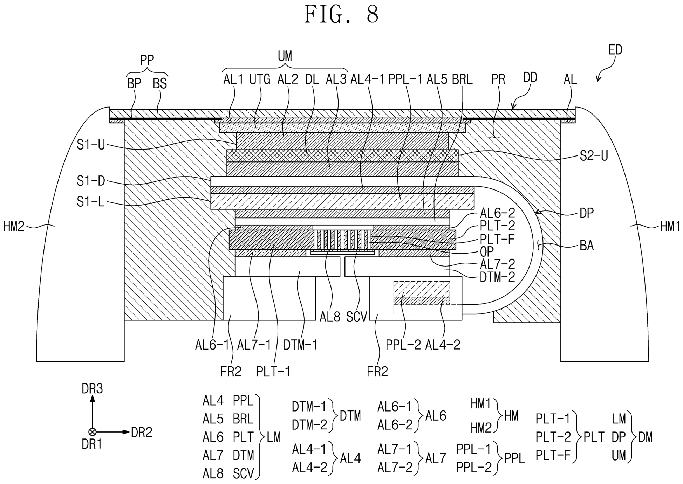

Referring to FIG. 8, the resin PR may be further attached to the hinge assembly HA provided below the display device DD. In FIG. 8, only the second frame FR2 of the hinge assembly HA illustrated in FIGS. 4A and 4B is briefly illustrated.

After attaching the hinge assembly HA to the lower side of the display device DD, if (e.g., when) the resin PR is applied to the side surface of the display module DM, a portion of the resin PR may be further attached to the side surface of the hinge assembly HA.

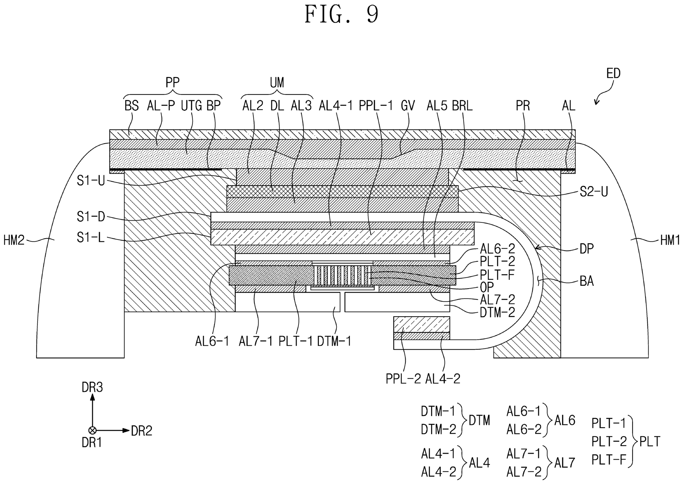

Referring to FIG. 9, the stacked structure of the protective member PP coupled to the housing HM may be changed. The protective member PP may include a base layer BS and a thin film glass substrate UTG provided below the base layer BS. The base layer BS and the thin film glass substrate UTG may be coupled to each other by an adhesive layer AL-P. The adhesive layer AL-P may be a resin, a pressure-sensitive adhesive layer, and/or an optically transparent adhesive layer. A groove GV overlapping the folding region FA0 may be defined on one surface of the thin film glass substrate UTG facing the base layer BS. In an embodiment of the present disclosure, the groove GV may be removed, and a flat thin film glass substrate UTG may be applied.

The bezel pattern BP may be on one surface of the thin film glass substrate UTG. The upper/lower positional relationship between the base layer BS and the thin film glass substrate UTG may be changed.

Referring to FIG. 10, the resin PR may have a closed line shape on a plane. In this embodiment, the resin PR may also be provided in the folding region FA0.

According to an embodiment of the present disclosure, the non-display region of the display device and the bezel region of the electronic device are reduced. The front surface of the electronic device may be provided using only the protective member and the housing of the display device. Because the protective member provided above the display device is directly attached to the housing, entrance of foreign substances into the inside of the electronic device may be prevented or reduced.

Because the resin protects the side surface of the display device, the impact resistance of the display device may be improved.

Although the above has been described with reference to preferred embodiments of the present disclosure, those skilled in the art or those of ordinary skill in the art will understand that various suitable modifications and changes can be made to the present disclosure within the technical scope of the present disclosure as defined by the appended claims.

Accordingly, the technical scope of the present disclosure should not be limited to the content described in the detailed description of the specification, but is defined by the appended claims.

## Claims

1. A display device (11) comprising:
a display panel (DP) configured to be foldable;
a protective member (PP) provided above the display panel (DP);
a lower member (LM) provided below the display panel (DP); and
a resin (PR) attached to at least a first side surface (S1-D) of the display panel (DP) and a first side surface (S1-L) of the lower member (LM) corresponding to the first side surface (S1-D) of the display panel (DP) and provided inside the protective member (PP) on a plane.

2. The display device (11) of claim 1, wherein the display panel (DP) comprises:
a first portion (AA1)facing the protective member (PP);
a second portion (AA2) provided below the lower member (LM); and
a third portion (BA) between the first portion (AA1) and the second portion (AA2) and bent.

3. The display device (11) of claim 2, further comprising a dummy resin (PR-D) attached to a second side surface (S2-L) of the lower member (LM) facing the third portion (BA) and between the second side surface (S2-L) of the lower member (LM) and the third portion (BA).

4. The display device (11) of claim 3, wherein the resin (PR) and the dummy resin (PR-D) comprise substantially the same material.

5. The display device (11) of any one of claims 2 to 4, wherein the first portion (AA1) comprises:
a first non-folding region (NFA1);
a second non-folding region (NFA2); and
a folding region (FA) between the first non-folding region (NFA1) and the second non-folding region (NFA2),
wherein:
the folding region (FA) extends in a first direction (DR1); and
the first non-folding region (NFA1) and the second non-folding region (NFA2) are spaced apart from each other along a second direction (DR2) crossing the first direction (DR1).

6. The display device (11) of claim 5, wherein:
the resin (PR) is further provided outside the third portion (BA); and
the first side surface (S1-D) of the display panel (DP) and the third portion (BA) are spaced apart from each other in the second direction (DR2).

7. The display device (11) of claim 5 or 6, wherein:
each of the display panel (DP) and the lower member (LM) further comprises a third side surface (S3-D, S3-L) and a fourth side (S4-L) surface facing each other in the first direction (DR1); and
the resin (PR) is attached to the third side surface (S3-D, S3-L) and the fourth side (S4-L) surface of each of the display panel (DP) and the lower member (LM).

8. The display device (11) of claim 7, wherein the resin (PR) is not attached to a region corresponding to the folding region (FA) of each of the third side surface (S3-D, S3-L) and the fourth side surface (S4-L).

9. The display device (11) of any one of the preceding claims, wherein the resin (PR) comprises a silicone-based resin, a urethane-based resin, a urethane acrylate-based resin, or a combination thereof.

10. The display device (11) of any one of the preceding claims, wherein, at a temperature of about -25 °C to about 80 °C, the resin (PR) has an elongation of about 50% or more and a storage modulus of about 10 MPa or less.

11. The display device (11) of any one of the preceding claims, wherein the resin (PR) has a closed-line shape on a plane.

12. An electronic device (ED) comprising:
a display device (11) of any one of the preceding claims;
a hinge assembly (HA) coupled to the display device (11) and configured to convert the display device (11) between an unfolded state and a folded state; and
a housing (HM) coupled to the display device (11) and the hinge assembly (HA), wherein the protective member (PP) is attached to the housing (HM).

13. The electronic device (ED) of claim 12, wherein:
the hinge assembly (HA) generates slip between the protective member (PP), the display panel (DP), and the lower member (LM) in the folded state; and
the lower member (LM) slips more than the display panel (DP) with respect to the protective member (PP).

14. The electronic device (ED) of claim 12 or 13, wherein the hinge assembly (HA) comprises:
a central frame (CF) corresponding to the folding region (FA);
a first frame (FR1) corresponding to the first non-folding region (NFA1) and hinge-coupled to the central frame (CF) via a first shaft (RX1) provided inside the central frame (CF); and
a second frame (FR2) corresponding to the first non-folding region (NFA1) and hinge-coupled to the central frame (CF) via a second shaft (RX2) provided inside the central frame (CF) and provided farther from the display device (11) than the first shaft (RX1),
wherein the display device (11) is coupled to the second frame (FR2).

15. An electronic device (ED) comprising:
a display device (11);
a hinge assembly (HA) coupled to the display device (11) and configured to convert the display device (11) between an unfolded state and a folded state; and
a housing (HM) coupled to the display device (11) and the hinge assembly (HA),
wherein the display device (11) comprises:
a protective member (PP) attached to the housing (HM);
a display panel (DP) provided below the protective member (PP) and comprising a bent portion (BA); and
a resin (PR) attached to an outer surface of the bent portion (BA) of the display panel (DP) and provided inside the protective member (PP) on a plane.
